Europäisches Patentamt

European Patent Office

Office européen des brevets

(11) Veröffentlichungsnummer: **0 219 795 B1**

# EUROPÄISCHE PATENTSCHRIFT

(45) Veröffentlichungstag der Patentschrift: **30.12.92**

(51) Int. Cl.⁵: **G03F 7/028**

(21) Anmeldenummer: **86114177.8**

(22) Anmeldetag: **14.10.86**

(54) **Durch Photopolymerisation vernetzbare Gemische.**

(30) Priorität: **17.10.85 DE 3536957**

(43) Veröffentlichungstag der Anmeldung:
**29.04.87 Patentblatt 87/18**

(45) Bekanntmachung des Hinweises auf die
Patenterteilung:
**30.12.92 Patentblatt 92/53**

(84) Benannte Vertragsstaaten:
**AT BE CH DE FR GB IT LI NL**

(56) Entgegenhaltungen:
**EP-A- 0 217 324**
**GB-A- 1 095 518**
**US-A- 4 339 527**
**US-A- 4 369 246**

**ULLMANNS ENZYKLOPÄDIE DER TECHNI-
SCHEN CHEMIE, Band 9, Ausgabe 4, 1975,
Seiten 480-481, Verlag Chemie, Weinheim,
DE; H. RASSAERTS et al.:
"Chlorkohlenwasserstoffe, aliphatische"**

**KIRK-OTMER ENCYCLOPEDIA OF CHEMICAL
TECHNOLOGY, Band 5, Ausgabe 3, 1979,
John Wiley & Sons, New York, US; B.A.
SCHENKER: "Chlorocarbons, -hydrocarbons
(paraffins)"**

(73) Patentinhaber: **BASF Aktiengesellschaft
Carl-Bosch-Strasse 38
W-6700 Ludwigshafen(DE)**

(72) Erfinder: **Hoffmann, Gerhard, Dr.
Pappelstrasse 22
W-6701 Otterstadt(DE)**

**Beschreibung**

Die Erfindung betrifft durch Photopolymerisation vernetzbare Gemische auf der Grundlage von löslichen elastomeren Blockcopolymerisaten, hiermit verträglichen photopolymerisierbaren Monomeren, Photoinitiatoren und Weichmachern, welche verbesserte anwendungstechnische Eigenschaften, insbesondere eine verbesserte Rißbeständigkeit im photovernetzten Zustand, besitzen.

Gemische auf der Grundlage von löslichen, elastomeren Blockcopolymerisaten, hiermit verträglichen photopolymerisierbaren Monomeren, Photoinitiatoren und Weichmachern sind z.B. aus GB-PS 1 366 769 bekannt. Als Weichmacher werden dort ölige Kohlenwasserstoffe, z.B. naphthenische oder paraffinische Öle; Polymere und Harze, z.B. Polystyrol, $\alpha$-Methylstyrol-Vinyltoluol-Copolymerisate, Polyterpen-Harze oder Polyethylen, oder Stearinsäure verwendet. Jedoch zeigen derartige Gemische einen erheblichen anwendungstechnischen Nachteil, nämlich Rißbildung bei der Verarbeitung, Lagerung und Anwendung von photopolymerisierten Massen und Formen, die aus diesen vernetzbaren Gemischen hergestellt worden sind. Rißbildung ist insbesondere bei Druckformen ein erhebliches Problem, da sie hier eine deutliche Verschlechterung der Lagerfähigkeit und der Wiederverwendbarkeit der Druckformen sowie der Druckerzeugnisse bedingt.

Ferner ist es aus GB-PS 1 095 518 bekannt, chlorierte Kohlenwasserstoffe mit einem Siedepunkt von über 300 °C als Weichmacher in Schichten aus kolloidalen Kautschuken und Arylaziden zur verwenden. Zur Rißbeständigkeit dieser Schichten nach ihrer Belichtung werden keine Angaben gemacht.

In der US-A-4 339 527 werden photopolymerisierbare Mischungen für die Herstellung von Photoresistfilmen beschrieben, die neben einem Photoinitiator sowie ethylenisch ungesättigten Monomeren ein filmbildendes polymeres Bindemittel (wie z.B. chlorierten Kautschuk oder ein Styrol-Dien-Blockcopolymerisat) sowie gegebenenfalls einen nicht polymerisierbaren Weichmacher, wie chlorierte Paraffine, enthalten. Diese photopolymerisierbaren Mischungen werden auf einen dimensionsstabilen Träger aufgebracht. In dieser USA wird jedoch nicht die Herstellung von Flexodruckplatten angesprochen.

Aufgabe der vorliegenden Erfindung war es, neue, durch Photopolymerisation vernetzbare Gemische zu finden, die den oben angeführten Nachteil nicht aufweisen und aus denen sich rißbeständige, durch Photopolymerisation vernetzte Massen und Formen, insbesondere Druckformen, herstellen lassen.

Gegenstand der vorliegenden Erfindung ist ein photopolymerisierbares Aufzeichnungselement für die Herstellung von Flexodruckplatten mit einem dimensionsstabilen Träger und einer darauf befindlichen photopolymerisierbaren, elastomeren Aufzeichnungsschicht aus

(a) 58 bis 92 Gew.-%, bezogen auf die Komponenten der photopolymerisierbaren, elastomeren Aufzeichnungsschicht, eines lösungsmittellöslichen elastomeren Blockcopolymerisats mit mindestens einem Polymerblock aus einem Vinylaromat und mindestens einem Polymerblock aus einem Dien,

(b) 5 bis 16 Gew.-%, bezogen auf die Summe der Komponenten der photopolymerisierbaren, elastomeren Aufzeichnungsschicht, mindestens eines photopolymerisierbaren, ethylenisch ungesättigten, mit dem elastomeren Blockcopolymerisat (a) verträglichen Monomeren,

(c) 0,4 bis 6 Gew.-%, bezogen auf die Summe der Komponenten der photopolymerisierbaren, elastomeren Aufzeichnungsschicht, mindestens eines Photoinitiators und

(d) 3 bis 22 Gew.-%, bezogen auf die Summe der Komponenten der photopolymerisierbaren, elastomeren Aufzeichnungsschicht, eines Chloralkans mit 8 bis 40 Kohlenstoffatomen und einem Chlorgehalt von ungefähr 49 Gew.-%.

Bevorzugt sind solche photopolymerisierbaren Aufzeichnungselemente für die Herstellung von Flexodruckplatten, die als Komponente (d) Chloralkan einer Dichte von 1,24 g/cm$^3$ aufweisen, insbesondere derartige Öle.

Bevorzugt sind außerdem solche photopolymerisierbaren Aufzeichnungselemente, deren photopolymerisierbare, elastomere Aufzeichnungsschicht 68 bis 82 Gew.-% von (a), 5 bis 12 Gew.-% von (b), 1,2 bis 2,5 Gew.-% von (c) und von 8 bis 18 Gew.-% von (d) enthält.

Für die Herstellung von Flexodruckplatten kann die erfindungsgemäße photopolymerisierbare, elastomere Aufzeichnungsschicht neben den Komponenten (a) bis (d) ferner

(e) bis zu 20 Gew.-% bezogen auf die Summe der Komponenten der photopolymerisierbaren, elastomeren Aufzeichnungsschicht, an weiteren Zusatz- und/oder Hilfsstoffen enthalten.

Als elastomere Blockcopolymere (a) sind dabei solche bevorzugt, die durch sequentielle anionische Polymerisation hergestellt worden sind.

Gegenstand der vorliegenden Erfindung ist auch ein Verfahren zur Herstellung von photopolymeren Flexodruckplatten mit verbesserter Rißbeständigkeit der Oberfläche durch bildweises Belichten eines photopolymerisierbaren Aufzeichnungselementes mit aktinischem Licht und Auswaschen der nichtbelichteten Anteile der photopolymerisierbaren Aufzeichnungsschicht des photopolymerisierbaren Aufzeichnungs-

2

elementes mit einem Entwicklerlösungsmittel, wobei erfindungsgemäße photopolymerisierbare Aufzeichnungselemente eingesetzt werden.

Im Hinblick auf den genannten Stand der Technik war es überraschend, daß die erfindungsgemäß anzuwendenden Chloralkane eine vorzügliche Weichmacherwirkung besitzen und darüber hinaus auch noch die Bildung von Rissen in den aus den erfindungsgemäßen Gemischen hergestellten, durch Photopolymerisation vernetzten Massen und Formen wirksam unterdrücken.

Im Rahmen der vorliegenden Erfindung werden Stoffe dann als "löslich" bezeichnet, wenn sie in üblichen Entwicklerlösungsmitteln für durch Photopolymerisation vernetzte Massen und Formen löslich sind, als "verträglich" werden sie bezeichnet, wenn sie in der Lage sind, ineinander dispergiert zu bleiben. Der Begriff "Massen" bezeichnet Materialien mit beliebiger äußerer Form, z.B. Klebmassen, Dichtungsmassen oder Folien ohne einen Gehalt an bildmäßiger Information, wohingegen unter dem Begriff "Formen" Materialien verstanden werden, die sich durch einen bildmäßigen Informationsgehalt auszeichnen, z.B. Druckformen und Photoresists.

Die erfindungsgemäßen Chloralkane enthalten 8 bis 40, vorzugsweise 11 bis 35 und insbesondere 12 bis 30 C-Atome und 30 bis 73 Gew.% Chlor. Man kann die reinen Chloralkane wie Trichlor-n-octan oder dessen Isomere verwenden (Chlorgehalt: 48,9 Gew.-%) oder z.B. Octachlor-n-octan oder dessen Isomere (Chlorgehalt: 72,8 Gew.-%), jedoch bevorzugt man die in der Technik anfallenden Gemische aus verschiedenen chlorierten Alkanen wie sie beispielsweise bei der Chlorierung von Kohlenwasserstoffen der Siedelage 195 bis 220°C oder 280 bis 320°C aus der Fischer-Tropsch-Synthese oder von wachsartigen Kohlenwasserstoffen, die üblicherweise als Paraffinwachse oder Hartparaffine bezeichnet werden, anfallen. Chloralkane dieser Art sind handelsübliche Produkte, für die sich die Bezeichnung "Chlorparaffine" eingebürgert hat. Sie sind Öle oder Feststoffe mit Erweichungspunkten Ep. $\leq$ 100°C, deren Dichte je nach Chlorgehalt zwischen 1,03 und 1,6 g cm$^{-3}$ liegt. Vorteilhafterweise werden sie in Mengen von 3 bis 22, insbesondere von 8 bis 18 Gew.-%, bezogen auf die durch Photopolymerisation vernetzbaren Gemische, angewendet, wobei die Öle bevorzugt werden.

Die Verwendung löslicher elastomerer Blockcopolymerisate in durch Photopolymerisation vernetzbaren Gemischen ist üblich. Hierfür sind insbesondere Vinylaromaten-Dien-Blockcopolymerisate geeignet, wobei diejenigen, welche durch chemische Verknüpfung von drei oder mehr elastomeren Dienpolymerisat-Blöcken oder von mindestens einem elastomeren Dienpolymerisat-Block und zwei oder mehr Vinylaromatenpolymerisat-Blöcken oder von zwei oder mehr elastomeren Dienpolymerisat-Blöcken und mindestens einem Vinylaromatenpolymerisat-Block gebildet werden, von Vorteil sind. Besonders vorteilhaft sind insbesondere diejenigen, in denen der Vinylaromat Styrol und das Dien Butadien und/oder Isopren ist. Darüber hinaus können solche Blockcopolymerisate über geeignete mehrbindige Atome oder Ionen sowie anorganische, organische oder metallorganische Molekülreste zu noch größeren Blockcopolymerisat-Verbänden chemisch verknüpft werden. Unter dem Begriff "chemische Verknüpfung" ist dabei die Herstellung kovalenter chemischer Bindungen, vorzugsweise von Kohlenstoff-Kohlenstoff-Einfachbindungen, zwischen den Polymerisat-Blöcken im Verlauf der Blockcopolymerisatsynthese zu verstehen. Blockcopolymerisate dieser Art sind aus DE-OS 28 15 678, DE-OS 29 39 989, DE-OS 29 42 183 und GB-PS 13 66 769 bekannt; sie werden durch sequentielle anionische Polymerisation hergestellt. Anschließend können ihre olefinischen und aromatischen Bindungen oder auch nur ihre olefinischen Bindungen in den Dienpolymerisat-Blöcken partiell oder vollständig hydriert werden. In den erfindungsgemäßen Gemischen sind die Blockcopolymerisate - einzeln oder als Mischung - in einer Menge von 92 bis 58, vorteilhafterweise von 85 bis 65 und insbesondere von 82 bis 68 Gew.-%, bezogen auf das Gemisch, enthalten. Unter Umständen können ihnen noch geringe Mengen an anderen Polymerisaten, insbesondere Elastomeren, beigemischt werden.

Übliche verträgliche photopolymerisierbare Monomere sind beispielsweise aus US-PS 2 760 863 oder US-PS 3 060 023 bekannt. Sie besitzen einen Siedepunkt von über 100°C bei Atmosphärendruck und ein Molgewicht von bis zu 3000, insbesondere von bis zu 2000. Geeignet sind die Ester der Acrylsäure und/oder Methacrylsäure mit ein- oder mehrwertigen Alkoholen, z.B. Butylacrylat, Butylmethacrylat, 2-Ethylhexylacrylat, Lauryl(meth)acrylat, Ethylenglykol-di(meth)acrylat, Butandiol-1,4-di(meth)acrylat, Neopentylglykol-di(meth)acrylat, 3-Methylpentandiol-di(meth)acrylat, 2-Hydroxipropyl(meth)acrylat, 2-Hydroxiethyl(meth)acrylat, Hexandiol-1,6-di(meth)acrylat, 1,1,1-Trimethylolpropantri(meth)acrylat, Di-, Tri- und Tetraethylenglykoldi(meth)acrylat, Tripropylenglykol-di(meth)acrylat oder Pentaerythrit-tetra(meth)-acrylat; die Vinylester aliphatischer Monocarbonsäuren, z.B. Vinyloleat; die Vinylether von Alkoholen, z.B. Octadecylvinylether und Butandiol-1,4-divinylether; die Diester von Fumar- und Maleinsäure, oder die Umsetzungsprodukte aus OH-terminierten, oligomeren Polybutadienen mit Maleinsäure oder (Meth)-Acrylsäure, d.h. oligomere Polybutadiene mit aktivierten, photopolymerisierbaren olefinischen Doppelbindungen. In den erfindungsgemäßen Gemischen werden sie - einzeln oder als Mischung - in einer Menge von 2 bis 16, vorteilhafterweise von 4 bis 14 und insbesondere 5 bis 12 Gew.-%, bezogen auf das Gemisch, verwendet.

Übliche verträgliche Photoinitiatoren sind beispielsweise Benzoin oder Benzoinderivate, wie dessen Methyl-, Isopropyl-, n-Butyl- oder Isobutylether; symmetrisch oder unsymmetrisch substituierte Benzilacetale, wie Benzildimethylacetal, Benzil-1-methyl-1-ethyl-acetal; oder Acyldiarylphosphinoxide gemäß DE-OS 29 09 992; oder substituierte und unsubstituierte Chinone, wie Ethylanthrachinon, Benzanthrachinon, Benzophenon oder 4,4′-Bis(dimethylamino)benzophenon. Sie können allein oder im Gemisch miteinander oder in Verbindung mit Coinitiatoren verwendet werden, z.B. Ethylanthrachinon mit 4,4′-Bis(dimethylamino)-benzophenon, Benzoinmethylether mit Triphenylphosphin, Diacylphosphinoxide mit tertiären Aminen oder Acyldiarylphosphinoxide mit Benzildimethylacetal. In den erfindungsgemäßen Gemischen werden sie in einer Menge von 0,4 bis 6, vorteilhafterweise von 0,7 bis 4 und insbesondere von 1,2 bis 2,5 Gew.-%, bezogen auf das Gemisch, verwendet.

Neben den Chloralkanen können die erfindungsgemäßen Gemische noch weitere Weichmacher enthalten, z.B. modifizierte und unmodifizierte Naturöle und -harze wie paraffinische oder naphthenische Öle sowie Erdölharze oder Pentaerythritolester von hydriertem Kollophonium; Alkyl-, Alkenyl-, Arylalkyl- oder Arylalkenylalkoholester von Säuren wie Zitronensäure, Essigsäure, Propionsäure , Buttersäure, Ethylbuttersäure, Ethylhexansäure, Glykolsäure, Benzoesäure, Phthalsäure, Trimellitsäure, Abietinsäure, Phosphorsäure oder Stearinsäure; synthetische Oligomere oder Harze wie Oligostyrol, oligomere Styrol-Butadien-Copolymerisate, Oligo-α-methylstyrol, oligomere α-Methylstyrol-Vinyltoluol-Copolymerisate, flüssige 1,2- oder 1,4-Oligobutadiene, Oligopentadiene, flüssige oligomere Acrylnitril-Butadien-Copolymerisate sowie Polyterpen-, Polyacrylat-, Polyester- oder Polyurethanharze; oder synthetische Polymere wie Polyethylen oder Ethylen-Propylen-Dien-Kautschuke. Üblich sind Mengen von 3 bis 25 Gew.-%, bezogen auf das erfindungsgemäße Gemisch.

Die erfindungsgemäßen Gemische können ferner noch weitere übliche Hilfs- und/oder Zusatzstoffe enthalten.

Hierzu gehören insbesondere Inhibitoren der thermisch initiierten Polymerisation, die im allgemeinen in einer Menge von 0,001 bis 2 Gew.%, bezogen auf das Gemisch, zugesetzt werden. Voraussetzung für die Auswahl derartiger Inhibitoren ist das Fehlen einer nennenswerten Eigenabsorption in dem aktinischen Bereich, in dem der Photoinitiator absorbiert. Geeignet sind Hydrochinon, p-Methoxiphenol, 2,6-Di-tert.-butyl-p-kresol, β-Naphthol, Phenothiazin, Pyridin, Nitrobenzol, m-Dinitrobenzol oder Chloranil; Thiazinfarbstoffe, wie Thioninblau G (C.I. 52025), Methylenblau B (C.I. 52015) oder Toluidinblau (C.I. 52040); oder N-Nitrosamine, wie N-Nitrosodiphenylamin, oder die Salze, beispielsweise die Kalium-oder Aluminiumsalze, des N-Nitrosocyclohexylhydroxylamins.

Zur Steuerung der Belichtungseigenschaften können den erfindungsgemäßen Gemischen Farbstoffe, Pigmente oder photochrome Zusätze in einer Menge von 0,0001 bis 2 Gew.-%, bezogen auf das Gemisch, zugesetzt werden. Derartige Zusätze können aber auch der Identifizierung, der direkten Kontrolle des Belichtungsergebnisses oder ästhetischen Zwecken dienen. Voraussetzung für die Auswahl und die Menge solcher Zusätze ist, daß sie - ebenso wenig wie die Inhibitoren der thermisch initiierten Polymerisation - die Photopolymerisation der Gemische stören.

Weiterhin können auch Mittel zur Verbesserung der Reliefstruktur der aus den erfindungsgemäßen Gemischen hergestellten Druckformen, wie beispielsweise 9,9′-Dianthronyl und 10, 10′-Bisanthron gemäß DE-OS 27 20 560, zugesetzt werden.

Die erfindungsgemäßen Gemische können ferner Vernetzungshilfsmittel wie die in US-PS 4 179 531 und US-PS 4 234 676 beschriebenen tri- und tetrafunktionellen Mercaptoverbindungen enthalten.

Zum Schutze der erfindungsgemäßen Gemische vor oxidativem und thermooxidativem Abbau durch Luftsauerstoff können ihnen wirksame Mengen an üblichen und bekannten Antioxidantien zugesetzt werden, z.B. sterisch gehinderte Monophenole wie 2,6-Di-tert.-butyl-p-kresol; alkylierte Thiobis-und Alkylidenbisphenole wie 2,2-Methylen-bis-(4-methyl-6-tert.-butylphenol) oder 2,2-Bis-(1-hydroxi-4-methyl-6-tert.-butylphenyl)sulfid; Hydroxibenzyle wie 1,3,5-Trimethyl-2,4,6-tris-(3,5-di-tert.-butyl-4-hydroxibenzyl)benzol; Triazine wie 2-(4-Hydroxi-3,5-tert.-butylanilino)-4,6-bis-(n-octylthio)-1,3,5-triazin; polymerisiertes Trimethyldihydrochinon; Zinkdibutyldithiocarbamat; Dilaurylthiodipropionat; oder Phosphite wie Tris(nonylphenyl)phosphit.

Gegebenenfalls können die erfindungsgemäßen Gemische auch übliche nicht mischbare polymere oder nicht polymere organische und anorganische Füllstoffe oder Verstärkerfüllstoffe enthalten, die für die Wellenlängen des zur Belichtung der erfindungsgemäßen Gemische verwendeten Lichts im wesentlichen durchlässig sind, dieses nicht streuen und in ihrem Brechungsindex weitgehend dem betreffenden Gemisch angepaßt sind. Als solche kommen in Frage Polystyrol, organophiles Siliciumdioxid, Bentonit, Kieselsäure, organophiles Aluminiumoxid, Glaspulver, kolloidaler Kohlenstoff sowie verschiedene Arten von Farbstoffen und Pigmenten. Diese Zusatzstoffe werden in Mengen verwendet, die mit den gewünschten Eigenschaften der erfindungsgemäßen Materialien variieren. Die Füllstoffe haben den Vorteil, daß sie die Festigkeit der erfindungsgemäßen Gemische verbessern, die Klebrigkeit verringern helfen und unter Umständen als farbgebende Mittel wirksam sind.

Die erfindungsgemäßen Gemische können ferner noch Flußmittel wie Calciumstearat und/oder Formtrennmittel wie Talkum in wirksamen Mengen enthalten sowie im Bedarfsfalle die dem Fachmann bekannten Antiozonantien, wie z.B. Ozonschutzwachse.

Für die Verwendung der erfindungsgemäßen Gemische als photopolymerisierbare Kleber und Dichtungsmassen empfiehlt es sich, klebrigmachende Harze, z.B. Paraffinharze, Kollophoniumester, Polyterpene, Cumaron-Inden-Harze oder Verbindungen gemäß US-PS 4 133 731 zuzusetzen.

Der Anteil der Zusatz- und/oder Hilfsstoffe soll im allgemeinen 20, insbesondere 10 Gew.-% der erfindungsgemäßen Gemische nicht überschreiten.

Die Herstellung der erfindungsgemäßen Gemische aus den Komponenten weist keine methodischen Besonderheiten auf; es können die üblichen Knet-, Misch- und Lösungstechniken angewendet werden.

Die so erhaltenen erfindungsgemäßen Gemische können direkt als photopolymerisierbare Kleber und Dichtungsmassen verwendet oder zu photopolymerisierten Folien und zu Formen, insbesondere Druckformen, weiterverarbeitet werden. Dazu werden sie in üblicher Weise durch Gießen aus einer Lösung, Heißpressen, Kalandrieren oder Extrudieren zu Flächengebilden der gewünschten Dicke geformt. Diese richtet sich im Falle der Formen in erster Linie nach dem Verwendungszweck der herzustellenden Druckform und variiert im allgemeinen von 0,2 bis 7, insbesondere von 0,7 bis 6,5 mm, da Druckformen dieser Dicke für die Mehrzahl der Drucktechniken geeignet sind. Im Falle Folien ist die Dicke beliebig.

Die Flächengebilde können als solche zu Druckformen verarbeitet werden; es ist jedoch üblich, sie im Verbund mit anderen schichtenförmigen Materialien herzustellen und dann erst weiterzuverarbeiten. Ein solcher Verbund wird allgemein als "Mehrschichtenelement" und das darin enthaltene Flächengebilde als "reliefbildende Schicht (RS)" bezeichnet.

Üblicherweise enthält ein solches Mehrschichtenelement eine reliefbildende Schicht (RS), die mit einem dimensionsstabilen Träger (T) haftfest verbunden ist. Der dimensionsstabile Träger (T) wiederum kann mit einer weichelastischen Unterschicht (U) gemäß DE-OS 24 44 118 unterlegt sein. Desweiteren kann auf die dem Träger (T) abgewandten Seite der Schicht (RS) eine Deckschicht (DS) und/oder eine Deckfolie (DF) aufgebracht werden. Werden Deckschicht (DS) und Deckfolie (DF) gemeinsam verwendet, dann liegt (DS) der Schicht (RS) direkt auf, und es kann sich zwischen (DS) und (DF) noch eine Antihaftschicht (AS) befinden. Ferner kann eine haftfeste Verbindung zwischen (T) und (RS) und gegebenenfalls (RS) und (DF) mit Hilfe einer Haftschicht (HS) erreicht werden.

Als dimensionsstabile Träger (T) werden üblicherweise Platten, Folien oder konische Röhren (sleeves) aus Metallen wie Stahl, Aluminium, Kupfer oder Nickel oder aus Hochpolymeren wie Polyethylenterephthalat, Polybutylenterephthalat, Polyamid oder Polycarbonat verwendet. Daneben kommen noch Gewebe und Vliese, z.B. Glasfasergewebe oder Verbundmaterialien aus z.B. Glasfasern und Hochpolymeren wie Polyethylenterephthalat in Frage.

Als Haftschichten (HS) werden üblicherweise 0,5 bis 40 $\mu$m dicke Haftlackschichten gemäß DE-OS 31 00 175 oder DE-OS 31 07 741 verwendet.

Übliche Deckschichten (DS) sind 0,5 bis 20 $\mu$m dick und können aus einem Polymeren bestehen, das lösliche, klebfreie, transparente und reißfeste Filme bildet, z.B. Polyamid, Copolyamid, Polyurethan, Polyvinylalkohol, Polyvinylpyrrolidon, Polyethylenoxid eines Molgewichts über 105 oder Cyclokautschuk mit einem hohen Cyclisierungsgrad. Gegebenenfalls kann (DS) mattiert sein.

Übliche Deckfolien (DF) sind 20 bis 150 $\mu$m dick und bestehen aus einem Polymeren wie Polyamid oder Polyethylenterephthalat.

Übliche Antihaftschichten (AS) sind 0,1 bis 0,5 $\mu$m dick und bestehen beispielsweise aus Silikonharzen gemäß EP 68 599.

Werden als Schichtträger (T) stark reflektierende Platten oder Folien verwendet, dann können sie übliche Lichthofschutzmittel, wie Ruß oder Mangandioxid, enthalten. Die Lichthofschutzmittel können aber als separate Schicht auf (T) aufgetragen werden oder in der Haftschicht (HS) oder der reliefbildenden Schicht (RS) enthalten sein.

Die Herstellung solcher Mehrschichtenelemente weist keine methodischen Besonderheiten auf. Üblicherweise erfolgt sie durch Auftragen der reliefbildenden Schicht (RS) auf dem Träger (T) mittels Gießen aus Lösung, Heißpressen, Kalandrieren oder Extrudieren. Auf dieses Zweischichtenelement können dann die anderen Schichten in bekannter Weise aufgebracht werden. Es ist aber auch möglich, die Schicht (RS) zuerst auf die mit einer Deckschicht (DS) bedeckten Seite einer Deckfolie (DF) aufzutragen und anschließend die unbedeckte Seite der Schicht (RS) mit dem Träger (T) haftfest zu verbinden.

Aus den Flächengebilden, die aus den erfindungsgemäßen Gemischen bestehen, oder aus den Mehrschichtenelementen, die reliefbildende Schichten (RS) aus solchen Gemischen enthalten, können in üblicher Weise Druckformen und photopolymerisierte Folien hergestellt werden. Diese Umwandlung von durch Photopolymerisation vernetzbaren Druckplatten in durch Photopolymerisation vernetzte Druckformen bildet auch bei der Verwendung der erfindungsgemäßen Gemische keine methodischen Besonderheiten. Sie erfolgt - gegebenenfalls nach einer Vorbehandlung - durch bildmäßiges Belichten der Druckplatten mit aktinischem Licht einer Wellenlänge zwischen 23O und 45O, vorteilhafterweise zwischen 3OO und 45O nm durch aufgelegte Negativvorlagen hindurch, Auswaschen der unbelichteten und daher unvernetzten Anteile der Druckplatten mit Hilfe geeigneter Entwicklerlösungsmittel, Trocknen der so erhaltenen Druckformen, die aus einer Reliefschicht (RS′) bestehen oder diese enthalten, und gegebenenfalls Nachbehandeln der Druckformen.

Übliche Vorbehandlungen sind z.B. das Abziehen einer gegebenenfalls in einem Mehrschichtenelement vorhandenen Deckfolie (DF) oder die vollflächige Belichtung der reliefbildenden Schicht (RS) mit aktinischem Licht von der Rückseite, d.h. von der der später druckenden Fläche abgewandten Seite her. Geeignete Lichtquellen für aktinisches Licht sind z.B. die Strahlung der Sonne oder handelsübliche UV-Fluoreszenzröhren, Quecksilbermittel-, -hoch- und -niederdruckstrahler, superaktinische Leuchtstoffröhren, Xenonimpulslampen, mit Metalliodiden dotierte Lampen oder Kohlebogenlampen.

Geeignete Entwicklerlösungsmittel sind übliche Lösungsmittel wie aromatische Kohlenwasserstoffe, z.B. Toluol oder Ethylbenzol; Chloralkane, z.B. 1,1,1-Trichlorethan, 1,1,2,2-Tetrachlorethan oder Tetrachlorethylen; Ketone, z.B. Methylisobutylketon; oder Mischungen solcher Lösungsmittel miteinander oder mit niederen Alkoholen, z.B. n-Butanol - letztere dienen der Steuerung der Auswaschwirkung.

Übliche Nachbehandlungen sind vollflächiges Nachbelichten der Druckformen oder Behandlung ihrer Oberflächen mit Halogen enthaltenden Bädern mit anschließendem Waschen, Trocknen und gegebenenfalls Nachbelichten.

Die Dicke der Reliefschicht (RS″) der Druckformen variiert je nach Anwendungszweck von 0,2 bis 7 mm. Für den Flexodruck sind Schichtdicken von 0,7 bis 6,5 mm von Vorteil.

Die in bekannter Weise erhaltenen Druckformen auf der Grundlage der erfindungsgemäßen Gemische können in üblicher Weise auf Druckzylinder aufgebracht, gegebenenfalls durch Coronaentladungen aufgerauht und für den Endlosdruck verwendet werden.

Es versteht sich von selbst, daß photopolymerisierte Massen, z.B. Folien, durch vollflächige Belichtung mit aktinischem Licht hergestellt werden, wobei dann die weiteren Verfahrensschritte entfallen.

Die erfindungsgemäßen Gemische weisen bei ihrer Herstellung und Verarbeitung zahlreiche Vorteile auf. So lassen sie sich aufgrund ihrer niedrigen Schmelzviskosität sehr leicht nach den üblichen Verfahren verarbeiten, wobei insbesondere ihre gute Dosierbarkeit in Krümelform das Beschichten von Extrudern erleichtert, wodurch sich im allgemeinen eine Mitverwendung von Trennmitteln erübrigt. Die verarbeiteten Massen und Formen sind klar und transparent, was vor allem erlaubt, Druckformen mit Reliefschichten (RS′) von sehr hoher Relieftiefe mit geradem Flankenaufbau herzustellen. Dies ist für das Bedrucken rauher, welliger Oberfläche, z.B. von Wellpappe, Kartonagen oder Servietten unbedingt erforderlich. Reliefhöhen von über 3 mm sind daher ohne Probleme wie bei konventionell geprägten Gummiklischees herstellbar, ohne daß es in der Tiefe der Schichten zum "Zupolymerisieren" kommt. Nicht zuletzt erlaubt die Klarheit der erfindungsgemäßen Gemische kurze Belichtungszeiten, ohne daß dies einen nicht aktzeptablen Polymerisationsgradienten in den Reliefschichten (RS′) zur Folge hätte. Die belichteten Massen und Formen sind stabil gegenüber äußeren chemischen und physikalischen Einflüssen. Insbesondere besitzen die Druckformen eine hohe Beständigkeit gegenüber Druckfarbenlösungsmitteln und eine hohe Abriebfestigkeit, was sehr hohe Druckauflagen ermöglicht. Der Hauptvorteil der verarbeiteten Massen und Formen aus den erfindungsgemäßen Gemischen sowie der belichteten Massen und Formen auf dieser Grundlage ist aber ihre äußerst geringe Neigung zur Rißbildung.

In den folgenden Beispielen wurden die Shore A-Härte nach DIN 53505, die Rückprallelastizität in Prozenten nach DIN 53512 und die Quellung der Proben in Gew.-% nach 24stündiger Lösungsmittelbehandlung mit einem Gemisch aus Ethanol (7 Gew.-Teile) und Essigsäureethylester (3 Gew.-Teile) bestimmt. Die Neigung zur Rißbildung wurde in einer Ozonkammer bei einer Ozonkonzentration von 50 ppm und bei einer Temperatur von 25°C an 10 cm langen Proben, die einer 10%igen Längendehnung unterworfen waren, bestimmt; Kriterium war hierbei der Zeitraum, nach dem die ersten Risse auftraten.

Beispiel 1

| 88,00 g | eines Styrol-Isopren-Styrol-Dreiblockcopolymerisates gemäß Beispiel IV der GB-PS 1 366 769 mit einem zahlenmittleren Molekulargewicht von 130 000, |
| 3,55 g | Hexandioldiacrylat, |
| 1,75 g | Hexandioldimethacrylat, |
| 1,25 g | Benzildimethylacetal, |
| 5,30 g | eines Chloralkans mit einem Chlorgehalt von 49 % und einer Dichte von 1,24 gcm$^{-3}$, |
| 5,30 g | eines Oligomeren aus 70 Teilen Vinyltoluol und 30 Teilen $\alpha$-Methylstyrol, |
| 0,53 g | 2,6-Di-tert.-butyl-p-kresol und |
| 0,006 g | Solvent Black 3 (C.I. 26150) |

wurden in 114,4 g Toluol bei 90°C gelöst. Die Lösung wurde auf die beschichtete Seite einer mit einem handelsüblichen Copolyamid (Macromelt der Firma Henkel) beschichteten, biaxial gereckten Polyethylenterephthalatfolie so aufgerakelt, daß nach der Trocknung der Schicht bei 80°C (Trocknungsdauer 1 Stunde) ein Film von 0,7 mm Dicke zurückblieb. Das so erhaltene Mehrschichtenelement wurde in einem handelsüblichen Flachbelichter (40 Watt, UV-Fluoreszenzlampen) während 30 Min. vollflächig belichtet. Die so erhaltene photopolymerisierte Schicht des belichteten Mehrschichtenelements stellte eine Folie ohne bildmäßigen Informationsgehalt mit einer Shore A-Härte von 39, einer Rückprallelastizität von 52 % und einer Quellung von 7,7 Gew.-% dar. Erste Risse traten nach 35 Min. auf.

Vergleichsversuch 1

Es wurde wie in Beispiel 1 verfahren, nur wurde der Anteil des erfindungsgemäßen Chloralkans ersetzt durch die gleiche Menge an Weißöl S 5000, einem üblicherweise als Weichmacher eingesetzten paraffinischen Öl. Die photopolymerisierte Schicht dieses belichteten Mehrschichtenelements war eine Folie ohne bildmäßigen Informationsgehalt mit einer Shore A-Härte von 41, einer Rückprallelastizität von 56 % und einer Quellung von 13,7 Gew.-% auf. Erste Risse wurden bereits nach 12 Min. beobachtet.

Vergleichsversuch 2

Es wurde wie im Vergleichsversuch 1 verfahren, nur daß dem Material noch 1 g eines handelsüblichen Ozonschutzwachses (Ozonschutzwachs Antilux 550 der Firma Rhein-Chemie, Rheinau GmbH) zugesetzt wurde. Shore A-Härte, Rückprallelastizität und Quellung der erhaltenen photopolymerisierten Folie ohne bildmäßigen Informationsgehalt entsprachen den Werten des Vergleichsversuchs 1. Erste Risse traten nach 25 Min. auf. Dies entsprach einer ca. 50%igen Verbesserung der Rißbeständigkeit gegenüber derjenigen aus Vergleichsversuch 1; das Niveau der Rißbeständigkeit der Folie gemäß Beispiel 1 wurde nicht erreicht.

Beispiel 2

Bei der Herstellung des erfindungsgemäßen Gemischs wurde wie in Beispiel 1 verfahren, nur daß der Anteil des Chloralkans von 5,3 auf 10,6 g verdoppelt und der Anteil des Blockcopolymerisats von 88,00 auf 82,70 g gesenkt wurde. Mit Hilfe dieses erfindungsgemäßen Gemischs wurde ein insgesamt 2 mm dickes Mehrschichtenelement gemäß der Patentschrift DE-OS 24 44 118, das auf der Oberseite eine 0,7 mm dicke Schicht aus dem erfindungsgemäßen Gemisch aufwies, hergestellt. Das Mehrschichtenelement wurde analog Beispiel 1 vollflächig belichtet. Die photopolymerisierte Schicht (= Folie) des Mehrschichtenelements besaß eine Shore A-Härte von 40, eine Rückprallelastizität von 42 % und eine Quellung von nur 1,9 Gew.-%. Risse traten erst nach 345 Minuten auf; dies entsprach einer Verbesserung gegenüber Vergleichsversuch 2 von über 1000 %!

Beispiel 3

Mit Hilfe des erfindungsgemäßen Gemischs gemäß Beispiel 2 wurde ein Mehrschichtenelement gemäß Beispiel 1 hergestellt, dessen reliefbildende Schicht (RS) eine Dicke von 1,7 mm - gegenüber 0,7 mm in Beispiel 1 -aufwies.

Zur Herstellung einer Flexodruckform aus diesem Mehrschichtenelement wurde zunächst auf die freie Oberfläche der reliefbildenden Schicht (RS) eine mit einem Haftlack beschichtete, 75 $\mu$m dicke Polyethylenterephthalatfolie aufgewalzt. Als Haftlack diente eine Mischung aus einem isocyanatgehärteten Phenoxiharz

EP 0 219 795 B1

und Polycarbonat demgemäß DE-OS 31 00 175. Anschließend wurde die Polyesterdeckfolie entfernt, wobei die Copolyamidschicht als Schutzschicht auf der Oberfläche der reliefbildenden Schicht (RS) verblieb.

Auf die mit dem Copolyamid bedeckten Seite der reliefbildenden Schicht (RS) wurde nun ein photographisches Negativbild als Vorlage aufgelegt und mit Hilfe eines Vakuumrahmens mit einer Folie angepreßt. Anschließend wurde mit einem handelsüblichen Flachbelichter (40 Watt, UV-Fluoreszenzröhren) durch die Negativvorlage hindurch während 12 Min. bildmäßig belichtet. Gleichzeitig mit der dabei ablaufenden Photopolymerisation wurde der in der reliefbildenden Schicht (RS) enthaltene Farbstoff ausgebleicht und ermöglichte so die direkte Beurteilung der Güte des Belichtungsergebnisses.

Die partiell photopolymerisierte reliefbildende Schicht (RS) des Mehrschichtenelements wurde in einem handelsüblichen Sprühwascher 4,5 Min. lang bei Raumtemperatur mit einem Lösungsmittelgemisch aus 9 Vol.-Teilen Tetrachlorethylen und 1 Vol.-Teil n-Butanol entwickelt, in einem Umlufttrockenschrank bei 80°C während einer Stunde getrocknet, 3 Minuten lang mit einer 0,4 Gew.-%igen wäßrigen Bromlösung nachbehandelt, nachgewaschen und erneut getrocknet.

Die in dieser Weise erhaltene Reliefschicht (RS) der Flexodruckform wurde während 10 Min. vollflächig nachbelichtet und auf einen Druckzylinder, der seinerseits mit einem 1 mm dicken Überzug aus Naturgummi einer Shore A-Härte von 30 beschichtet war, aufgespannt.

Die klebfreie Oberfläche der Flexodruckform nahm die üblichen Flexodruckfarben ausgezeichnet an. Die Abriebfestigkeit, Quellung und Elastizität der Druckform entsprach derjenigen herkömmlicher Gummiklischees. Die erhaltenen Druckergebnisse zeigten eine exakte Wiedergabe der Vorlage mit randscharfen Details. Die Druckform ihrerseits wies selbst nach einer Auflage von 200 000 Drucken keinerlei Beschädigung und Risse auf.

**Patentansprüche**

1. Photopolymerisierbares Aufzeichnungselement für die Herstellung von Flexodruckplatten mit einem dimensionsstabilen Träger und einer darauf befindlichen photopolymerisierbaren, elastomeren Aufzeichnungsschicht aus

    (a) 58 bis 92 Gew.-%, bezogen auf die Komponenten der photopolymerisierbaren, elastomeren Aufzeichnungsschicht, eines lösungsmittellöslichen elastomeren Blockcopolymerisats mit mindestens einem Polymerblock aus einem Vinylaromat und mindestens einem Polymerblock aus einem Dien,

    (b) 5 bis 16 Gew.-%, bezogen auf die Summe der Komponenten der photopolymerisierbaren, elastomeren Aufzeichnungsschicht, mindestens eines photopolymerisierbaren, ethylenisch ungesättigten, mit dem elastomeren Blockcopolymerisat (a) verträglichen Monomeren,

    (c) 0,4 bis 6 Gew.-%, bezogen auf die Summe der Komponenten der photopolymerisierbaren, elastomeren Aufzeichnungsschicht, mindestens eines Photoinitiators und

    (d) 3 bis 22 Gew.-%, bezogen auf die Summe der Komponenten der photopolymerisierbaren, elastomeren Aufzeichnungsschicht, eines Chloralkans mit 8 bis 40 Kohlenstoffatomen und einem Chlorgehalt von ungefähr 49 Gew.-%.

2. Photopolymerisierbares Aufzeichnungselement für die Herstellung von Flexodruckplatten gemäß Anspruch 1, dadurch gekennzeichnet, daß das Chloralkan (d) eine Dichte von 1,24 g/cm$^3$ hat.

3. Photopolymerisierbares Aufzeichnungselement für die Herstellung von Flexodruckplatten gemäß einem der Ansprüche 1 oder 2, dadurch gekennzeichnet, daß das Chloralkan (d) ein Öl ist.

4. Photopolymerisierbares Aufzeichnungselement für die Herstellung von Flexodruckplatten nach einem der Ansprüche 1 bis 3, dadurch gekennzeichnet, daß die photopolymerisierbare, elastomere Aufzeichnungsschicht 68 bis 82 Gew.-% von (a), 5 bis 12 Gew.-% von (b), 1,2 bis 2,5 Gew.-% von (c) und von 8 bis 18 Gew.-% von (d) enthält.

5. Photopolymerisierbares Aufzeichnungselement für die Herstellung von Flexodruckplatten nach einem der Ansprüche 1 bis 4, dadurch gekennzeichnet, daß die photopolymerisierbare, elastomere Aufzeichnungsschicht neben den Komponenten (a) bis (d) ferner

    (e) bis zu 20 Gew.-%, bezogen auf die Summe der Komponenten der photopolymerisierbaren, elastomeren Aufzeichnungsschicht, an weiteren Zusatz- und/oder Hilfsstoffen enthält.

6. Photopolymerisierbares Aufzeichnungselement für die Herstellung von Flexodruckplatten nach einem der Ansprüche 1 bis 5, dadurch gekennzeichnet, daß das elastomere Blockcopolymer (a) durch sequentielle anionische Polymerisation hergestellt worden ist.

7. Verfahren zur Herstellung von photopolymeren Flexodruckplatten mit verbesserter Rißbeständigkeit der Oberfläche durch bildweises Belichten eines photopolymerisierbaren Aufzeichnungselementes mit aktinischem Licht und Auswaschen der nichtbelichteten Anteile der photopolymerisierbaren Aufzeichnungsschicht der photopolymerisierbaren Aufzeichnungselementes mit einem Entwicklerlösungsmittel, dadurch gekennzeichnet, daß ein photopolymerisierbares Aufzeichnungselement nach einem der Ansprüche 1 bis 6 eingesetzt wird.

**Claims**

1. A photopolymerizable recording element for the production of flexographic printing plates, having a dimensionally stable substrate and a photopolymerizable, elastomeric recording layer which is present thereon and comprising

   (a) from 58 to 92% by weight, based on the components of the photopolymerizable, elastomeric recording layer, of a solvent-soluble elastomeric block copolymer having at least one polymer block of a vinylaromatic and at least one polymer block of a diene,

   (b) from 5 to 16% by weight, based on the sum of the components of the photopolymerizable, elastomeric recording layer, of at least one photopolymerizable, ethylenically unsaturated monomer compatible with the elastomeric block copolymer (a),

   (c) from 0.4 to 6% by weight, based on the sum of the components of the photopolymerizable, elastomeric recording layer, of at least one photoinitiator and

   (d) from 3 to 22% by weight, based on the sum of the components of the photopolymerizable, elastomeric recording layer, of a chloroalkane having 8 to 40 carbon atoms with a chlorine content of about 49% by weight.

2. A photopolymerizable recording element for the production of flexographic printing plates as claimed in claim 1, wherein the chloroalkane (d) has a density of 1.24 g/cm$^3$.

3. A photopolymerizable recording element for the production of flexographic printing plates as claimed in either of claims 1 or 2, wherein the chloroalkane (d) is an oil.

4. A photopolymerizable recording element for the production of flexographic printing plates as claimed in any of claims 1 to 3, wherein the photopolymerizable, elastomeric recording layer contains from 68 to 82% by weight of (a), from 5 to 12% by weight of (b), from 1.2 to 2.5% by weight of (c) and from 8 to 18% by weight of (d).

5. A photopolymerizable recording element for the production of flexographic printing plates as claimed in any of claims 1 to 4, wherein the photopolymerizable, elastomeric recording layer contains, in addition to components (a) to (d),

   (e) up to 20% by weight, based on the sum of the components of the photopolymerizable, elastomeric recording layer, of further additives and/or assistants.

6. A photopolymerizable recording layer for the production of flexographic printing plates as claimed in any of claims 1 to 5, wherein the elastomeric block copolymer (a) has been prepared by sequential anionic polymerization.

7. A process for the production of a photopolymeric flexographic printing plate having improved crack resistance of the surface by imagewise exposure of a photopolymerizable recording element to actinic light and washing out the unexposed parts of the photopolymerizable recording layer of the photopolymerizable recording element with a developer, wherein a photopolymerizable recording element as claimed in any of claims 1 to 6 is used.

**Revendications**

1. Elément d'enregistrement photopolymérisable pour la fabrication de plaques d'impression flexographiques, comprenant un support à dimensions stables et, sur celui-ci, une couche d'enregistrement élastomère photopolymérisable consistant elle-même en

a) 58 à 92 % en poids, par rapport aux composants de la couche d'enregistrement élastomère photopolymérisable, d'un copolymère séquencé élastomère soluble dans les solvants, à au moins un bloc polymère consistant en un composé vinylaromatique et au moins un bloc polymère consistant en un diène,

b) 5 à 16 % en poids, par rapport à la somme des composants de la couche d'enregistrement élastomère photopolymérisable, d'au moins un monomère à insaturation éthylénique photopolymérisable compatible avec le copolymère séquencé élastomère (a),

c) 0,4 à 6 % en poids, par rapport à la somme des composants de la couche d'enregistrement élastomère photopolymérisable, d'au moins un photo-inducteur, et

d) 3 à 22 % en poids, par rapport à la somme des composants de la couche d'enregistrement élastomère photopolymérisable, d'un chloralcane contenant 8 à 40 atomes de carbone et à une teneur en chlore d'environ 49 % en poids.

2. Elément d'enregistrement photopolymérisable pour la fabrication de plaques d'impression flexographiques selon la revendication 1, caractérisé en ce que le chloralcane (d) a une densité de 1,24 g/cm$^3$.

3. Elément d'enregistrement photopolymérisable pour la fabrication de plaques d'impression flexographiques selon une des revendications 1 ou 2, caractérisé en ce que le chloralcane (d) est une huile.

4. Elément d'enregistrement photopolymérisable pour la fabrication de plaques d'impression flexographiques selon une des revendications 1 à 3, caractérisé en ce que la couche d'enregistrement élastomère photopolymérisable contient 68 à 82 % en poids de (a), 5 à 12 % en poids de (b), 1,2 à 2,5 % en poids de (c) et 8 à 18 % en poids de (d).

5. Elément d'enregistrement photopolymérisable pour la fabrication de plaques d'impression flexographiques selon une des revendications 1 à 4, caractérisé en ce que la couche d'enregistrement élastomère photopolymérisable, en plus des composants (a) à (d), contient encore :

e) jusqu'à 20 % en poids, par rapport à la somme des composants de la couche d'enregistrement élastomère photopolymérisable, d'autres additifs et/ou produits auxiliaires.

6. Elément d'enregistrement photopolymérisable pour la fabrication de plaques d'impression flexographiques selon une des revendications 1 à 5, caractérisé en ce que le copolymère séquencé élastomère (a) a été préparé par polymérisation anionique séquencée.

7. Procédé pour la fabrication de plaques d'impression flexographiques photopolymères à résistance améliorée aux fissures de surface par exposition d'un élément d'enregistrement photopolymérisable à la lumière actinique avec formation d'une image et lavage des régions non exposées de la couche d'enregistrement photopolymérisable de l'élément d'enregistrement photopolymérisable par un solvant révélateur, caractérisé en ce que l'on utilise un élément d'enregistrement photopolymérisable selon une des revendications 1 à 6.